# EUROPEAN PATENT APPLICATION

(11) **EP 4 125 137 A1**
(43) Date of publication of application: **01.02.2023**
(21) Application number: 21188123.0
(22) Date of filing: 28.07.2021
(51) Int. Cl.: H01L 31/0224, H01L 31/05, H01L 31/068

(54) **SOLAR CELL MODULE**

(71) Applicant: Meyer Burger (Switzerland) AG, 3645 Gwatt/Thun (CH)
(72) Inventor: HÄNNI, Simon, 3604 Thun (CH); KUNZ, Daniel, 3638 Blumenstein (CH); WALTHER, Jörg, 09130 Chemnitz (DE)
(74) Representative: Vissel, Horst Friedrich Georg

(57) **Abstract**

Examples provide a solar cell module (1000) comprising a fist solar cell string (2010, 2020, 2030), wherein the first solar cell string (2000) includes a first solar cell (2010) and a second solar cell (2020) electrically connected in series, wherein the first solar cell (2010) and the second solar cell (2020) are electrically connected via a plurality of parallel connecting wires (2110, 2210); and an interconnector (2261) crossing at least some of the connecting wires (2210), in particular being arranged perpendicular to the connecting wires (2210), and electrically connecting the at least some connecting wires (2210); wherein the interconnector (2261; 5060) comprises an interconnector core (5062) having a first surface facing the connecting wires (2210) and a second surface; wherein the first surface is covered with a first coating (5061) and the second surface is covered with a second coating (5063), wherein the first coating (5061) is thicker than the second coating (5063).

## Description

The disclosure relates to a solar cell module.

WO 2015/001413 A1 discloses a solar cell module, sometimes also called photovoltaic module, comprising several solar cell strings, wherein each solar cell string comprises several solar cells connected in series. The solar cells are arranged between a front-side encapsulation layer and a back-side encapsulation layer.

Further, WO 2011/011855 A1 proposes a method for connecting several rear contact solar cells, in particular interdigitated back contact (IBC) solar cells. In particular, solar cell strings may be formed by electrically connecting several solar cells in series using a plurality of parallel connecting wires.

Typically, interconnectors are used to connect solar cell strings together, either in series or in parallel. The interconnectors comprise an interconnector core having a coating. The coating may be melted for electrically connecting the interconnectors to the connecting wires. It has been found that occasionally parts of the molten coating may not stick to the interconnector and lead to visual and/or electrical degradation of the solar cell module.

Thus, there may be a need for a solar cell module being less prone to failure.

Said need has been addressed with the subject-matter of the independent claim. Advantageous embodiments are described in the dependent claims.

Examples disclose a solar cell module comprising a fist solar cell string, wherein the first solar cell string includes a first solar cell and a second solar cell electrically connected in series, wherein the first solar cell and the second solar cell are electrically connected via a plurality of parallel connecting wires; and an interconnector crossing at least some of the connecting wires, in particular being arranged perpendicular to the connecting wires, and electrically connecting the at least some connecting wires; wherein the interconnector comprises an interconnector core having a first surface facing the connecting wires and a second surface; wherein the first surface is covered with a first coating and the second surface is covered with a second coating, wherein the first coating is thicker than the second coating.

In an embodiment of the solar cell module, the first coating may be made of a first coating material, the connecting wires may comprise a wire core and a wire coating, the wire coating is made of a wire coating material, and the first coating material differs from the wire coating material. This may allow for adapting the wire coating material specifically for the connection with the solar cells and the fist coating material for the connection with the connecting wires.

Some embodiments may prescribe that the second coating is made of a second coating material, wherein the second coating material differs from the first coating material. For example, the first coating material may be optimized for providing a good electrical and mechanical contact to the connecting wires while the second coating material may be optimized to improve the optical appearance of the solar cell module. For example, an Sn- or In-based first coating material may be used and an Ni-based second coating material.

The first coating material and/or the wire coating material comprises a solder. Soldering may provide a good electrical and, optionally mechanical, connection between the parts soldered together. In examples, the solder may be SnPb consisting of 63 weight-% Sn and 37 weight-% Pb and having an eutectic temperature of 183 °C. Preferably, the solder is a lead-free solder. Examples of lead-free solders include InSn consisting of 52 weight-% In and 48 weight-% Sn and having an eutectic temperature of 118 °C, SnBi consisting of 42 weight-% Sn and 58 weight-% Bi and having an eutectic temperature of 139 °C as well as SnBiAg consisting of 42 weight-% Sn, 57 weight-% Bi and 1 weight-% ag. Further examples of useable solders are disclosed in Spinella et al., "Thermomechanical fatigue resistance of low temperature solder for multiwire interconnects in photovoltaic modules", https://doi.Org/10.1016/j.solmat.2021.111054 and Abtew et al., "Lead-free Solders in Microelectronics", https://doi.org/10.1016/S0927-796X(00)00010-3.

In some examples, a melting point of the first coating material is higher than a melting point of the wire coating material. This may avoid that the first coating material is re-molten when the connecting wires are soldered to the solar cells. However, in other examples, a melting point of the first coating material may also be equal to a melting point of the wire coating material.

The first coating may have a thickness above 10 µm, in particular above 21 µm, more particularly above 29 µm. This may ensure a sufficient adhesion force between the connecting wires and the interconnector.

Some examples may prescribe that the first coating has a thickness below 40 µm, in particular below 30 µm. This may keep the costs for the first coating material reasonably low. In some examples, the first coating may also have a thickness below 20 µm.

The interconnector and the solar cells may be arranged on a same side of the connecting wires. This may facilitate manufacturing of the solar cell module in case the solar cells are rear contact cells. However, it is also conceivable that the interconnector and the solar cells are arranged on opposite sides of the connecting wires.

The solar cell module may comprise a cover laminate and a back laminate, wherein the solar cell string is laminated between the cover laminate and the back laminate, wherein the cover laminate and the back laminate are configured to be laminated together at a laminating temperature being higher than the melting temperature of the wire coating material. Accordingly, the connecting wires may be soldered to the solar cells upon laminating.

The laminating temperature may be lower than the melting temperature of the first coating material. Hence, a pre-soldered connection between the interconnector and the connecting wires may be maintained during laminating.

The solar cell module may comprise a second solar cell string, wherein the interconnector electrically connects connecting wires associated with a first polarity of the first solar cell string and connecting wires associated with a second polarity of the second solar cell string.

Alternatively or in addition, the solar cell module may also comprise a second solar cell string, wherein the interconnector electrically connects connecting wires associated with a first polarity of the first solar cell string and connecting wires associated with the first polarity of the second solar cell string.

In some examples, the solar cell string and module comprises foil segments; wherein the connecting wires are arranged between the foil segments and the solar cells, wherein the foil segments adhere to the solar cells and fix a position of the connecting wires with respect to the solar cells.

The solar cells of the solar cell module may be rear contact solar cells, in particular interdigitated back contact solar cells.

The interconnector may have an essentially rectangular cross-section.

Examples of the proposed solar cell module are described with respect to the drawing in which:
Fig. 1 illustrates a solar cell module;
Fig. 2 illustrates a solar cell string;
Fig. 3 illustrates a connecting wire and an interconnector;
Fig. 4 illustrates a connecting wire and an interconnector,
Fig. 5 illustrates a connecting wire and an interconnector,
Fig. 6 illustrates a solar cell module.

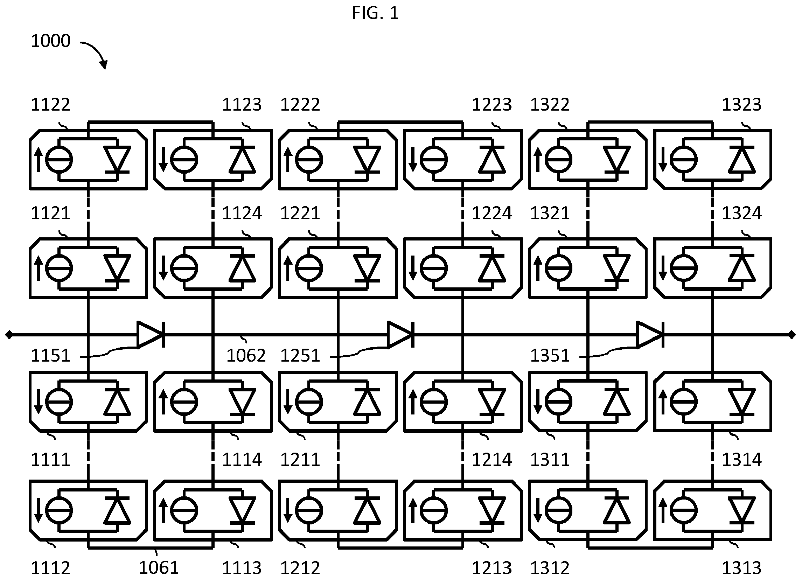

Fig.1 shows a first solar cell module 1000 with a plurality of solar cell strings 1121, 1122, 1123, 1124; 1221, 1222, 1223, 1224; 1321, 1322, 1323, 1324; 1111, 1112, 1113, 1114; 1211, 1212, 1213, 1214 and 1311, 1312, 1313, 1314. The solar cell module may also be called a photovoltaic module. The solar cell string 1121, 1122, 123, 1124 may also be considered as a first solar cell string. The first solar cell string comprises a plurality, in particular at least two, solar cells 1121, 1122, 1123, and 1124 connected in series. Fig. 1 shows four solar cells connected in series per solar cell string. However, it is also conceivable that each solar cell string comprises eight, ten, twelve or, in particular, twenty solar cells. The solar cells of the first solar cell string are arranged in two columns. One column comprises the solar cells 1121 and 1122 whereas the other column comprises the solar cells 1123 and 1124. The further solar cells strings of the solar cell module 1000 are constructed equally, wherein the solar cell strings 1111, 1112, 1113, 1114; 1211, 1212, 1213, 1214 and 1311, 1312, 1313, 1314 are arranged mirror symmetrically to the solar cell strings 1121, 1122, 1123, 1124; 1221, 1222, 1223, 1224 and 1321, 1322, 1323, 1324. Accordingly, the solar cell module 1000 may comprise six times twenty solar cells, which are arranged in twenty lines and six columns. The number of lines and, accordingly, the number of solar cells per solar cell string may be varied. Likewise, more or less solar cell strings may be used such that the number of columns may also deviate. Examples may also provide that the solar cell strings of the lower half of the solar cell module 1000 as it is shown in Fig. 1 may be omitted.

A first bridging element 1151 is connected in parallel to the first solar cell string 1121, 1122, 1123, 1124. Similarly, a second bridging element 1251 and a third bridging element 1351 are connected in parallel to the second solar cell string 1221, 1222, 1223, 1224 and the third solar cell string 1321, 1322, 1323, 1324, respectively. The bridging elements 1151, 1251, 1351 shown in Fig. 1 are diodes. However, the diodes may be replaced with different bridging element, e.g. active switches.

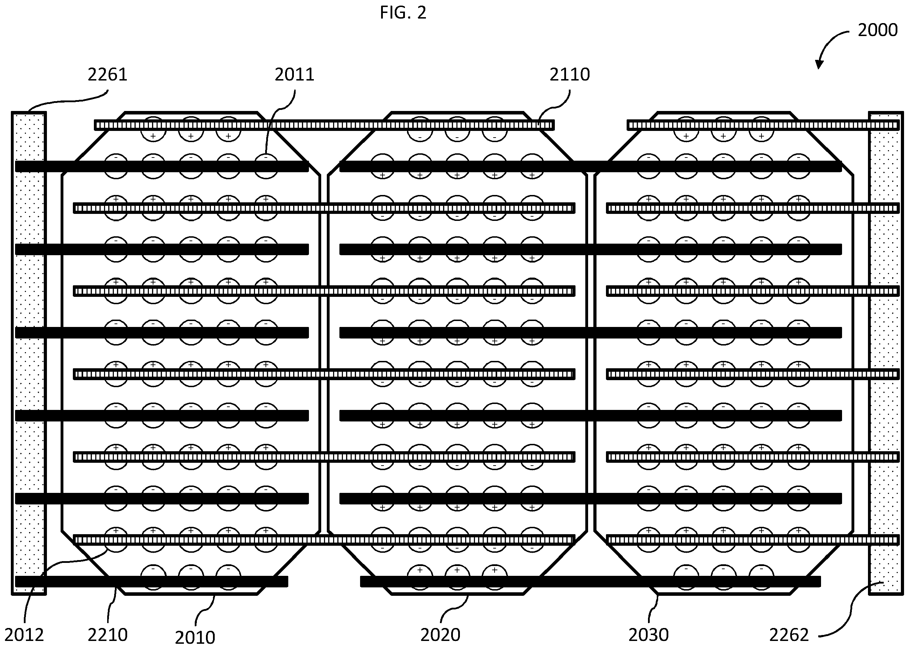

Fig. 2 shows a solar cell string comprising three solar cells 2010, 2020, 2030 connected in series. The solar cells 2010, 2020, 2030 are provided with backside contacts 2011, 2012 of opposite polarity. A plurality of parallel connecting wires 2110 and 2210 connect the solar cells 2010, 2020, 2030 in series. Interconnectors 2260, 2262 are crossing the connecting wires 2110, 2210. In the example shown in Fig. 2 the interconnectors 2261, 2262 are arranged perpendicular to the connecting wires 2110, 2210. The interconnector 2261 electrically connects a first group of connecting wires 2210 and the interconnector 2262 connects a second group of connecting wires. The interconnectors 2261, 2262 may correspond to the connectors 1061, 1062 shown in Fig. 1. The interconnectors 2261 2262 may also be called ribbons or "Querverbinder" (German) or "Stringverbinder" (German).

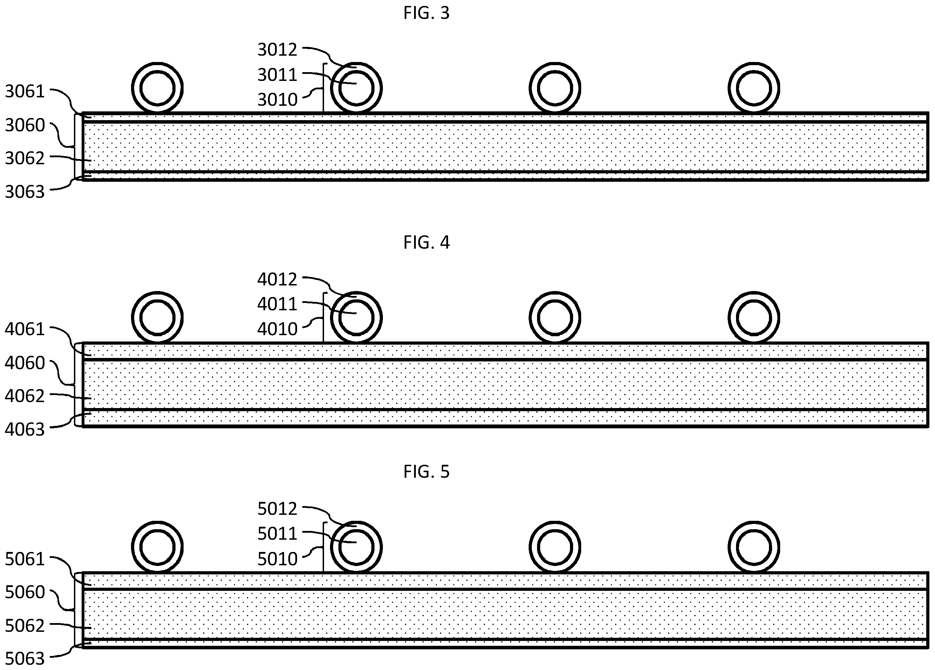

Fig. 3 shows an interconnector 3060 crossing a plurality of connecting wires 3010. The interconnector 3060 comprises an interconnector core 3062 having a first surface facing the connecting wires 3010 and a second surface. The first surface is covered with a first coating 3061 and the second surface is covered with a second coating.3063. The first coating 3061 is made of a first coating material. The interconnector core 3062 may have an essentially rectangular cross-section. The connecting wires 3010 may comprise a wire core 3011 and a wire coating 3012. The first coating material and/or the wire coating material comprise a solder. In examples, the wire coating 3012 may be molten to provide solder contacts between the connecting wires and the contacts of the solar cells. Likewise, the first coating 3061 may be molten to provide solder contacts between the connecting wires 3010 and the interconnector 3060. In the example shown in Fig. 3, the thicknesses of the first coating 3061, the second coating 3063 and the wire coating 3012 are equal. Said thickness may amount to 17 +/-3 µm.

Fig. 4 shows an interconnector 4060 crossing a plurality of connecting wires 4010. The interconnector 4060 comprises an interconnector core 4062 having a first surface facing the connecting wires 4010 and a second surface. The first surface is covered with a first coating 4061 and the second surface is covered with a second coating 4063. The first coating 4061 and the second coating 4063 are made of a first coating material and have the same thickness. The interconnector core 4062 may have an essentially rectangular cross-section. The connecting wires 4010 may comprise a wire core 4011 and a wire coating 4012. The first coating material and/or the wire coating material comprise a solder. In examples, the wire coating 4012 may be molten to provide solder contacts between the connecting wires and the contacts of the solar cells. Likewise, the first coating 4061 may be molten to provide solder contacts between the connecting wires 4061 and the interconnector 4060.

Recently, it has been observed that the soldering adhesion may be improved by increasing the thickness of the first coating 4061 with respect to the thickness of the wire coating 4012. The increase in adhesion force with increasing thickness is illustrated in Table 1. In the experiment, the connecting wire had a wire coating with a thickness of 17 +/-3 µm.

**Table 1**

| | thickness of the first coating in µm | | |
|---|---|---|---|
| adhesion force in Newton for one connecting wire | 14-20 | 20-30 | 30-40 |
| maximum | 1.12 | 1.38 | 1.94 |
| minimum | 0.68 | 0.80 | 0.88 |
| average | 0.89 | 1.01 | 1.33 |

It has been observed that the increased thickness of the first coating 4061 (being equal to the thickness of the second coating 4063) improves the connection between the interconnector 4060 and the connecting wires 4010. However, the molten first and second coating 4061, 4063 may tend to flow towards an edge of the solar cell module in form of spikes or small coating bubbles. For increased module efficiency the distance from the last current transporting portion of the solar cell module to the edge of the solar cell module, in particular, to the edge of the glass covering the solar cell module should be minimized. The spikes and/or bubbles increase the risk that a required minimum distance between the current transporting portions of the solar cell module and the edge of the solar cell module cannot be maintained without the risk of a failure of the solar cell module. The current transporting portions of the solar cell module may also be called live parts of the module.

Thus, it is proposed a configuration as illustrated in Fig. 5. The interconnector 5060 crosses a plurality of connecting wires 5010. The connecting wires 5010 correspond to the connecting wires 3010 and 4010 and comprise a wire core 5011 and a wire coating 5012. The material of the wire core 5011 may essentially comprise copper and/or aluminium. The interconnector 5060 comprises an interconnector core 5062 having a first surface facing the connecting wires 5010 and a second surface. The first surface is covered with a first coating 5061 and the second surface is covered with a second coating 5062. The first coating 5061 is thicker than the second coating 5063. Thus, the total amount of required interconnector coating material may be reduced. For a given thickness of the first coating 5061 this may reduce the risk of solar cell module failures due to spikes and/or bubbles. Moreover, the reduced amount of interconnector coating material my reduce the material costs of the solar cell module. The first coating material and/or the wire coating material may comprise a solder. A melting point of the first coating material may be higher than a melting point of the wire coating material. This may ensure that the first coating material is not molten another time when the wire coating material is molten.

The first coating 5061 is made of a first coating material. The second coating 5063 is made of a second coating material. The first coating material may be the same as the second coating material. This may ensure that the visual appearance of the interconnector does not depend on the direction from which a person looks at the solar cell module. The material of the interconnector core 5062 may comprise essentially copper and/or aluminium.

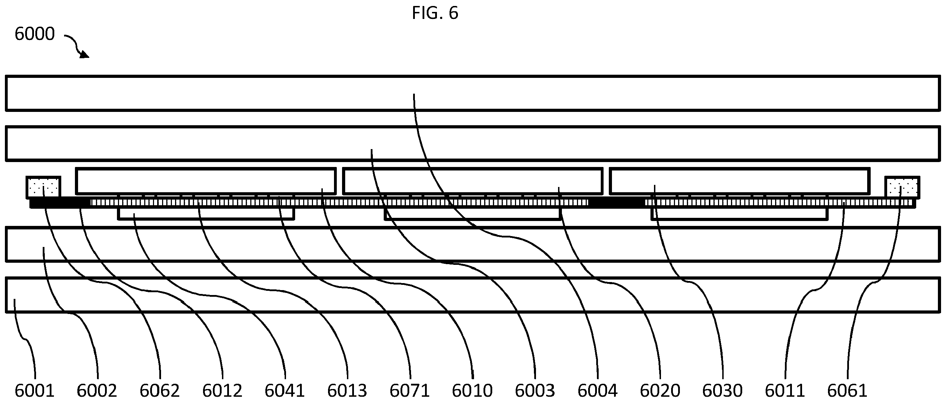

Fig. 6 shows a solar cell module 6000 in cross-section. The solar cell module 6000 comprises a first solar cell string, wherein the first solar cell string includes a first solar cell 6010, a second solar cell 6020 and a third solar cell 6030 electrically connected in series via a plurality of parallel connecting wires 6011, 6012. An interconnector 6061 crosses the connecting wires 6011 and an interconnector 6062 crosses the connecting wires 6012. The interconnectors 6061, 6062 have a first surface facing the connecting wires 6011, 6012 and a second surface. The first surface of the interconnectors 6061, 6062 is covered with a first coating (not shown) and the second surface is covered with a second coating, wherein the first coating is thicker than the second coating. The connecting wire 6011 may correspond to the connecting wire 2110 shown in Fig. 2 and the connecting wire 6012 may correspond to the connecting wire 2210 shown in Fig. 2.

For manufacturing the solar cell module, the parallel connecting wires 6011, 6012 and foil segments 6041 may be provided. The foil segments 6041 may at least temporarily fix the relative position of the connecting wires 6011, 6012. Afterwards, the solar cells 6010, 6020, 6030 may be arranged on the foil segments 6041 such that the connecting wires 6011, 6012, 6013 are arranged between the foil segments 6041 and the solar cells 6010, 6020, 6030. The foil segments 6041 may comprise an adhesive for temporarily fixing the solar cells 6010, 6020, 6030 to the respective foil segment 6041. The interconnectors 6061, 6062 may be positioned on the connecting wires 6011, 6012. Inductive heating may be used to melt the first coating material of the interconnectors 6061, 6062 and to at least pre-solder the interconnectors 6061, 6062 to the connecting wires 6011, 6012. The foil segments 6041, connecting wires 6011, 6012, solar cells 6010, 6020, 6030 and the interconnectors 6061, 6062 may be arranged between a cover laminate 6003 and a back laminate 6002. A cover glass 6004 and/or a back glass 6001 may also be provided. Heat may be applied to laminate the stack together. The laminating temperature may be higher than a melting temperature of a wire coating material of the wire coating of the connecting wires 6011, 6012 and lower than a melting temperature of a first coating material of the first coating of the interconnectors 6061, 6062. Thus, the connecting wires 6011, 6012 may be soldered to the contacts 6071 of the solar cells 6010, 6020, 6030. The laminating temperature may be between 120 °C and 180 °C, in particular between 135 °C and 165 °C.

## Claims

1. Solar cell module (1000) comprising
a fist solar cell string (2000),
wherein the first solar cell string (2000) includes a first solar cell (2010) and a second solar cell (2020) electrically connected in series,
wherein the first solar cell (2010) and the second solar cell (2020) are electrically connected via a plurality of parallel connecting wires (2110, 2210); and
an interconnector (2261) crossing at least some of the connecting wires (2210), in particular being arranged perpendicular to the connecting wires (2210), and electrically connecting the at least some connecting wires (2210);
wherein the interconnector (2261; 5060) comprises an interconnector core (5062) having a first surface facing the connecting wires (2210) and a second surface;
wherein the first surface is covered with a first coating (5061) and the second surface is covered with a second coating (5063),
wherein the first coating (5061) is thicker than the second coating (5063).

2. Solar cell module (1000) according to claim 1,
wherein the first coating (5061) is made of a first coating material,
wherein the connecting wires (5010) comprise a wire core (5011) and a wire coating (5012),
wherein the wire coating (5012) is made of a wire coating material, wherein the first coating material differs from the wire coating material.

3. Solar cell module (1000) according to claim 2,
wherein the first coating material and/or the wire coating material comprises a solder.

4. Solar cell module (100) according to any one of claims 1 to 3, wherein the second coating is made of a second coating material, and wherein the second coating material differs from the first coating material.

5. Solar cell module (1000) according to any one of claims 2 to 4,
wherein a melting point of the first coating material is higher than a melting point of the wire coating material.

6. Solar cell module (1000) according to any one of claims 1 to 5,
wherein the first coating (5061) has a thickness above 10 µm, in particular above 21, more particularly above 29 µm.

7. Solar cell module (1000) according to any one of claims 1 to 6,
wherein the first coating (5061) has a thickness below 40 µm, in particular below 30 µm, more particularly below 20 µm.

8. Solar cell module (1000) according to any one of claims 1 to 7,
wherein the interconnector (6061, 6062) and the solar cells (6010, 6020, 6030) are arranged on a same side of the connecting wires (6011, 6012).

9. Solar cell module (1000) according to any one of claims 1 to 8,
wherein the interconnector (6061, 6062) and the solar cells (6010, 6020, 6030) are arranged on opposite sides of the connecting wires (6011, 6012).

10. Solar cell module (1000) according to any one of claims 1 to 9,
wherein the solar cell module (1000) comprises a cover laminate (6003) and a back laminate (6002),
wherein the solar cell string (6010, 6020, 6030) is laminated between the cover laminate (6003) and the back laminate (6002),
wherein the cover laminate (6003) and the back laminate (6002) are configured to be laminated together at a laminating temperature being higher than the melting temperature of the wire coating material.

11. Solar cell module (1000) according to any one of claims 5 to 10,
wherein the laminating temperature is lower than the melting temperature of the first coating material.

12. Solar cell module (1000) according to any one of claims 1 to 11,
wherein the solar cell module (1000) comprises a second solar cell string,
wherein the interconnector electrically connects connecting wires associated with a first polarity of the first solar cell string and connecting wires associated with a second polarity of the second solar cell string.

13. Solar cell module (1000) according to any one of claims 1 to 11,
wherein the solar cell module (1000) comprises a second solar cell string,
wherein the interconnector electrically connects connecting wires associated with a first polarity of the first solar cell string and connecting wires associated with the first polarity of the second solar cell string.

14. Solar cell module (1000) according to any one of claims 1 to 13,
wherein the solar cell module (1000) comprises foil segments (6041);
wherein the connecting wires are arranged between the foil segments and the solar cells,
wherein the foil segments (6041) adhere to the solar cells and fix a position of the connecting wires with respect to the solar cells.

15. Solar cell module (1000) according to any one of claims 1 to 14,
wherein the solar cells (6010, 6020) are rear contact solar cells, in particular interdigitated back contact solar cells.

16. Solar cell module (1000) according to any one of claims 1 to 15,
wherein the interconnector (5060, 6061, 6062) has an essentially rectangular cross-section.
